# EUROPEAN PATENT SPECIFICATION

(11) **EP 0 784 915 B1**
(45) Date of publication and mention of the grant of the patent: **05.02.2003**
(21) Application number: 95932288.4
(22) Date of filing: 14.09.1995
(51) Int. Cl.: H05K 13/04

(54) **ACCURATE REPRODUCTION OF LARGE AND SMALL COMPONENTS**
GENAUE WIEDERGABE VON GROSSEN UND KLEINEN KOMPONENTEN
REPRODUCTION PRECISE DE COMPOSANTS GRANDS ET PETITS

(30) Priority: 14.09.1994 SE 9403095; 07.10.1994 SE 9403417
(43) Date of publication of application: 23.07.1997
(73) Proprietor: MYDATA AUTOMATION AB, 161 70 Bromma (SE)
(72) Inventor: JACOBSSON, Nils, S-161 70 Bromma (SE)
(74) Representative: Rosenquist, Per Olof
(86) International application number: SE9501046
(87) International publication number: WO96010325

(56) References cited:
- US-A- 4 951 383
- US-A- 5 251 266

## Description

### TECHNICAL FIELD

The present invention relates to devices for reproducing accurately surfaces of electronic components, which can have different sizes.

### BACKGROUND AND STATE OF THE ART

In machines for automatic mounting of electronic components on printed circuit boards, a very high accuracy is required for the positioning of a component, see e.g. the general discussion in U.S. patent US-A 5,251,266. The accuracy can be achieved by retaining and positioning the component in a predetermined manner or in a predetermined position on a pickup head and by capturing, after that, an image of its attachment surface, here termed its bottom surface, and by analysing the captured image automatically. In the case contemplated herein, the picking head is hence in a predetermined position and an image is captured of the component. However, the electronic components exist in very varying sizes, from a outer dimensions of below 1 mm to components having outer dimensions of 40 - 50 mm. If a reproduction system is fixedly and permanently adjusted for large components, so that a video camera over its projection area captures the whole image of large components, the same adjustment for a smaller component will result in an image, which can be poorly used for a position determination, since the image of the actual component will then cover comparatively few pixels of the photo sensitive surface of the video camera.

To achieve reproductions of varying magnifications, it would be possible to employ a suitable, zoom type system of lenses, but it turns out that these not are sufficiently stable at different settings and that they, in particular, are not repeatable for changes of the lens system for different magnifications. Hence, at different settings of the degree of magnification, the image will, for instance, in a non-controllable or non-repeatable manner be displaced in different, lateral, directions. However, a repeatable, stable reproduction of a side of component can be achieved by arranging a beam-splitter and two video cameras having different magnifications, as is disclosed in the published European patent application EP-A1 0 449 481, the U.S. patents US-A 5,172,468 and US-A 4,951,383 and the Japanese patent applications JP-A 6-112 690 and JP-A 6-125 195.

### SUMMARY

It is an object of the invention to provide a device, by means of which accurate reproductions of electronic components of varying sizes, for an accurate mounting thereof on a printed circuit board, can be achieved.

In mounting electronic components of different sizes, two image capture devices having light or photo sensitive means, such as video cameras and lens systems, are used. Light rays from the surface of the component are directed to the light sensitive surfaces of video cameras through lens system and a fixedly arranged beam splitter. Commercially available colour video cameras comprise a suitable beam splitter and the basic configuration thereof is used, by modifying the light sensitive elements to such having different sizes but the same internal resolutions and by removing the colour filters.

Thus, according to the invention, a device for accurately capturing images from a surface of a component has at least two image capture devices which each one has a light sensitive surface. An optical system such as a beam splitter is placed and arranged so that light rays emitted from the surface of the component reach the light sensitive surfaces. The light sensitive surfaces have different dimensions, one being substantially smaller than another one, for instance one having half the linear dimensions of another one and the same own resolution, that is the same number of scanning lines, picture elements, etc.. Then the image capture device associated with each light sensitive surface will produce pictures with fields of view having different sizes but with the same inherent resolution. A large component surface can be captured by a large light sensitive surface and a small component surface can be captured by a small light sensitive surface so that images of the component surfaces will each one cover a substantial or major portion of the generated, complete respective picture.

The light sensitive surfaces can thus comprise different numbers of individual picture receiving elements per area unit to provide digitalized pictures with a lower effective resolution for large components and a higher effective resolution for small components.

A single focusing means such as a lens system can be arranged between the location of the surface of a component and the beam splitter. The beam splitter means can comprise a composite prism for dividing the incoming light in light beams directed to the respective light sensitive surfaces.

The imaging system can be used in a component mounting machine according to claim 6, comprising a picking head for gripping, holding, transporting and accurate positioning of electronic component and suitable driver means for bringing the picking head to a predetermined positions.

### BRIEF DESCRIPTION OF THE DRAWINGS

The invention will now be described with reference to the accompanying drawings, in which
Fig. 1 is a schematic view from the side of a device for an accurate reproduction of the bottom surface of electronic components of different sizes implemented by modifying a colour video camera,
Fig. 2 is a perspective view of a component assembly device.

### DETAILED DESCRIPTION

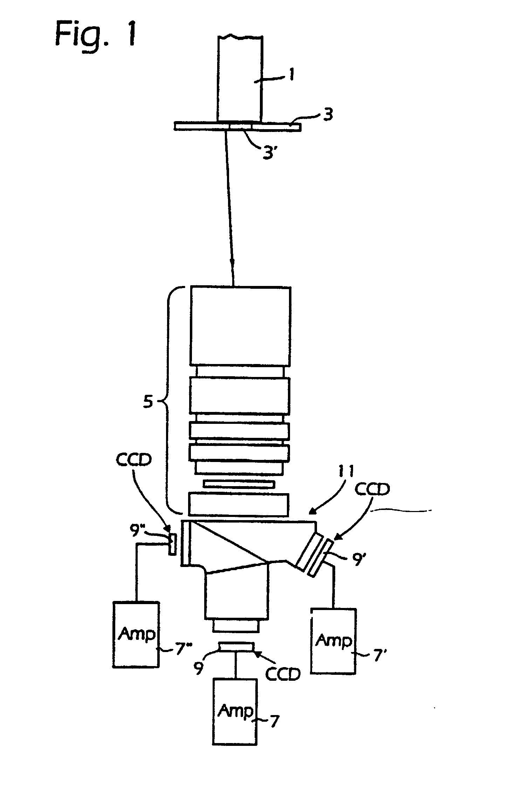

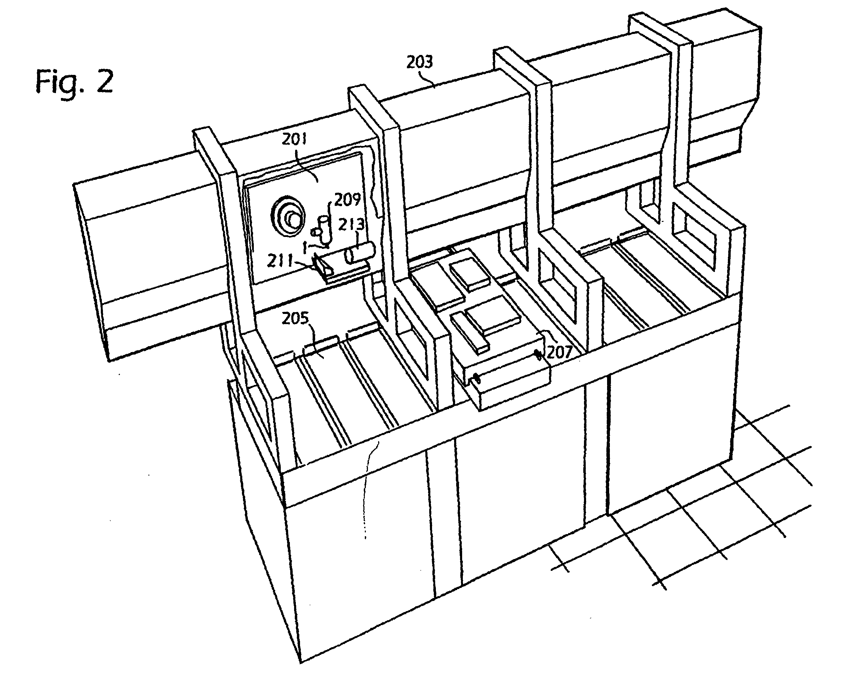

In Fig. 1 a portion of a picking head or component holding head 1 is shown of an automatic mount machine for electronic components, see Fig. 2. The pickup head 1 holds an electronic component 3 and the bottom of the electronic component is reproduced by means of a fixedly adjusted lens system 5 on the active, light detecting surfaces 9, 9', 9" of a modified video camera. The component head 1 can be adjusted to be located in very accurately determined positions both laterally, in one coordinate direction in the preferred embodiment of a mounting machine, and in an elevation direction.

A prism system 11 divides a primary light beam incident to the lens system 5 into three, secondary light beams, having different directions, one secondary light beam going straight through the prism, a second light beam being effectively deflected 90° and a third light beam being deflected about 60° to the side opposite to that of the second secondary light beam. These secondary light beams reach the light sensitive elements 9, 9' and 9" of CCD type, connected to three separate amplifier units 7, 7' and 7" respectively. In a colour video camera, all the CCD elements are the same type and are equipped with a suitable colour filter for typically red, yellow and blue light (RYB) and the video camera outputs a composite video signal, which represents the measured signal value of each point for every such colour. If the CCD elements are instead of different types, for instance having the same total number of pixel points and having different numbers of pixel points per unit area, i.e. that the CCD elements 9, 9', 9" all have the same number of total pixel points but have differently sized active surfaces, different degrees of magnification and different fields of view are achieved for the different images. The device illustrated in Fig. 1 has only one lens system and has commercially available main parts, and it can thus be manufactured at a low cost.

In Fig. 2 a component assembly or pick-and-place machine is illustrated in a perspective view showing the general configuration of such a machine. A wagon 201 is movable along a horizontal bar 203 to different locations, such as above magazine sites 205 intended to hold component feeders, which are movable in a horizontal direction perpendicular to the guide bar 203 and above a printed circuit board 207 retained on a slide, also movable in the same direction as the magazine sites 205. The wagon 201 carries a pickup unit 209, at the lower side of which a vacuum nozzle 1 is located which can be moved vertically and rotated about a vertical axis. The nozzle can pass through a frame 211 carrying suitable optical devices for directing light from a component to a modified video camera 213.

## Claims

1. A device for accurately capturing images from a surface of a component, comprising
- at least two image capture devices (7,7',7") having light sensitive surfaces (9,9',9") and
- a beam splitter means (11), placed and arranged so that light rays emitted from the surface of the component reach the light sensitive surface on each of the at least two image capture devices,
**characterized in that** the light sensitive surfaces have different dimensions, one being substantially smaller than another one, the image capture device associated with each light sensitive surface thus producing pictures with fields of view having different sizes, whereby a large component surface can be captured by a large light sensitive surface and a small component surface can be captured by a small light sensitive surface to provide pictures of the component surfaces each one covering a substantial portion of the generated, complete respective picture.

2. A device according to claim 1, **characterized in that** the light sensitive surfaces all comprise the same number of individual picture receiving elements to provide digital pictures.

3. A device according to one of claims 1 - 2, **characterized in that** the light sensitive surfaces comprise different numbers of individual picture receiving elements per area to provide digitalized pictures.

4. A device according to one of claims 1 - 3, **characterized by** a focusing means arranged between the location of the surface of a component and the beam splitter means for focusing light rays from the surface to form an image thereof on each one of the light sensitive surfaces, in particular these images being substantially equal to each other.

5. A device according to one of claims 1 - 4, **characterized in that** the beam splitter means comprises a composite prism for dividing the incoming light in light beams directed to the respective light sensitive surfaces.

6. A component mounting machine comprising a pickup head (1) for gripping, holding, transport and accurate positioning electronic components, comprising
means for bringing the pickup head to predetermined positions,
means for an accurate capturing of images of a surface of the component (3) when the picking head is in one predetermined position, which means comprise at least two image capture devices having light sensitive surfaces and a beam splitter,
**characterized in that** the beam splitter and the light sensitive surface are so arranged that essentially the same image of a component, in particular an image having the same size, is formed on each of the light sensitive surfaces, and that the light sensitive surfaces have different dimensions, one being substantially smaller than another one, the image capture device associated with each light sensitive surface thus producing pictures with fields of view having different sizes, whereby a large component surface can be captured by one light sensitive surface and a small component surface can be captured by another light sensitive surface to provide images of the component surfaces which images each one covers a substantial portion of the generated respective complete picture that is fully recorded by the light sensitive surfaces and their associated capture devices.

## Patentansprüche

1. Vorrichtung zum genauen Erfassen von Bildern von einer Fläche eines Bauteils, die umfasst:
wenigstens zwei Bilderfassungsvorrichtungen (7, 7', 7"), die lichtempfindliche Flächen (9, 9', 9") aufweisen, und
eine Strahlteilereinrichtung (11), die so angeordnet und ausgeführt ist, dass von der Fläche des Bauteils emittierte Lichtstrahlen die lichtempfindliche Fläche an jeder der wenigstens zwei Bilderfassungsvorrichtungen erreichen,
**dadurch gekennzeichnet, dass** die lichtempfindlichen Flächen unterschiedliche Abmessungen haben, wobei eine erheblich kleiner ist als die andere und die mit jeder lichtempfindlichen Fläche verbundene Bilderfassungsvorrichtung so Bilder mit Bildfeldern unterschiedlicher Größe herstellt, so dass eine große Bauteilfläche mit einer großen lichtempfindlichen Fläche erfasst werden kann und eine kleine Bauteilfläche mit einer kleinen lichtempfindlichen Fläche erfasst werden kann, um Bilder der Bauteilflächen bereitzustellen, die jeweils einen erheblichen Teil des erzeugten vollständigen jeweiligen Bildes einnehmen.

2. Vorrichtung nach Anspruch 1, **dadurch gekennzeichnet, dass** die lichtempfindlichen Flächen sämtlich die gleiche Anzahl einzelner Bildempfangselemente zum Erzeugen digitaler Bilder umfassen.

3. Vorrichtung nach einem der Ansprüche 1-2, **dadurch gekennzeichnet, dass** die lichtempfindlichen Flächen unterschiedliche Anzahlen einzelner Bildaufnahmeelemente pro Bereich zum Erzeugen digitalisierter Bilder umfassen.

4. Vorrichtung nach einem der Ansprüche 1-2, **gekennzeichnet durch** eine Fokussiereinrichtung, die zwischen der Position der Fläche eines Bauteils und der Strahlteilereinrichtung angeordnet ist, um Lichtstrahlen von der Fläche zu fokussieren und ein Bild derselben auf jeder der lichtempfindlichen Flächen zu erzeugen, wobei diese Bilder einander im Wesentlichen gleichen.

5. Vorrichtung nach einem der Ansprüche 1-4, **dadurch gekennzeichnet, dass** die Strahlteilereinrichtung ein Verbundprisma umfasst, das das auftreffende Licht in Lichtstrahlen teilt, die auf die jeweiligen lichtempfindlichen Flächen gerichtet sind.

6. Bauteil-Anbringungsmaschine, die einen Aufnehmkopf (1) zum Ergreifen, Halten, Transportieren und genauen Positionieren elektronischer Bauteile umfasst, die umfasst:
eine Einrichtung, die den Aufnehmkopf an vorgegebene Positionen bringt,
eine Einrichtung, die genaue Bilder einer Fläche des Bauteils (3) erfasst, wenn sich der Aufnehmkopf an einer vorgegebenen Position befindet, wobei die Einrichtung wenigstens zwei Bilderfassungsvorrichtungen mit lichtempfindlichen Flächen sowie einen Strahlteiler umfasst,
**dadurch gekennzeichnet, dass** der Strahlteiler und die lichtempfindliche Fläche so ausgeführt sind, dass im Wesentlichen das gleiche Bild eines Bauteils, d.h. ein Bild mit der gleichen Größe, auf jeder der lichtempfindlichen Flächen ausgebildet wird, und dass die lichtempfindlichen Flächen unterschiedliche Abmessungen haben, wobei eine erheblich kleiner ist als die andere und die mit jeder lichtempfindlichen Fläche verbundene Bilderfassungsvorrichtung so Bilder mit Bildfeldern unterschiedlicher Größe erzeugt, so dass eine große Bauteilfläche mit einer lichtempfindlichen Fläche erfasst werden kann und eine kleine Bauteilfläche mit einer anderen lichtempfindlichen Fläche erfasst werden kann, um Bilder der Bauteilflächen bereitzustellen, wobei die Bilder jeweils einen erheblichen Abschnitt des erzeugten jeweiligen Gesamtbildes einnehmen, das durch die lichtempfindlichen Flächen und ihre damit verbundenen Erfassungsvorrichtungen insgesamt aufgezeichnet wird.

## Revendications

1. Dispositif destiné à acquérir avec précision des images d'une surface d'un composant, comprenant
- au moins deux dispositifs d'acquisition d'image (7, 7', 7'') présentant des surfaces photosensibles (9, 9', 9'') et
- un moyen de division de faisceau (11), placé et agencé de sorte que les rayons de lumière émis à partir de la surface du composant atteignent la surface photosensible sur chacun des au moins deux dispositifs d'acquisition d'image,
**caractérisé en ce que** les surfaces photosensibles présentent des dimensions différentes, l'une étant sensiblement plus petite qu'une autre, le dispositif d'acquisition d'image associé à chaque surface photosensible présentant ainsi des images avec des champs de visualisation ayant des tailles différentes, d'où il résulte qu'une grande surface de composant peut être acquise par une grande surface photosensible et qu'une petite surface de composant peut être acquise par une petite surface photosensible afin de réaliser des images des surfaces de composants, chacune couvrant au moins une partie substantielle de l'image finale générée.

2. Dispositif selon la revendication 1, **caractérisé en ce que** les surfaces photosensibles comprennent toutes le même nombre d'éléments de réception d'image individuels pour fournir les images numériques.

3. Dispositif selon l'une des revendications 1 et 2, **caractérisé en ce que** les surfaces photosensibles comprennent des nombres différents d'éléments de réception d'image individuels par zone afin de réaliser les images numérisées.

4. Dispositif selon l'une des revendications 1 à 3, **caractérisé par** un moyen de focalisation agencé entre l'emplacement de la surface d'un composant et le moyen de division de faisceau en vue de focaliser les rayons de lumière provenant de la surface pour former une image de celle-ci sur chacune des surfaces photosensibles, en particulier ces images étant sensiblement égales les unes aux autres.

5. Dispositif selon l'une des revendications 1 à 4, **caractérisé en ce que** le moyen de division de faisceau comprend un prisme composite destiné à diviser la lumière entrante en faisceaux de lumière dirigés vers les surfaces photosensibles respectives.

6. Machine de montage de composants comprenant une tête de prélèvement (1) en vue de la saisie, du maintien, du transport et du positionnement précis des composants électroniques, comprenant
un moyen destiné à amener la tête de prélèvement à des positions prédéterminées,
un moyen destiné à acquérir avec précision des images d'une surface du composant (3) lorsque la tête de prélèvement se trouve à une position prédéterminée, lequel moyen comprend au moins deux dispositifs d'acquisition d'image comportant des surfaces photosensibles et un diviseur de faisceau,
**caractérisée en ce que** le diviseur de faisceau et la surface photosensible sont agencés de sorte que pratiquement la même image d'un composant, en particulier une image présentant la même taille, soit formée sur chacune des surfaces photosensibles, et que les surfaces photosensibles présentent des dimensions différentes, une étant sensiblement plus petite qu'une autre, le dispositif d'acquisition d'image étant associé à chaque surface photosensible en produisant ainsi des images avec des champs de visualisation ayant des tailles différentes, d'où il résulte qu'une grande surface du composant peut être acquise par une surface photosensible et qu'une petite surface de composant peut être acquise par une autre surface photosensible afin de fournir des images des surfaces de composants, lesquelles images couvrent chacune une partie substantielle de l'image finale respective générée qui est entièrement enregistrée par les surfaces photosensibles et leurs dispositifs d'acquisition associés.
